# EUROPEAN PATENT APPLICATION

(11) **EP 4 304 043 A1**
(43) Date of publication of application: **10.01.2024**
(21) Application number: 22763426.8
(22) Date of filing: 04.03.2022
(51) Int. Cl.: H02J 7/00, H01M 10/42, H01M 10/48

(54) **BATTERY PACK MANAGEMENT SYSTEM**

(30) Priority: 05.03.2021 US 202163157251 P; 15.09.2021 US 202163244598 P
(71) Applicant: Nuvoton Technology Corporation Japan, Nagaokakyo City Kyoto 617-8520 (JP)
(72) Inventor: SAKAKIBARA, Tsutomu, Nagaokakyo City, Kyoto 617-8520 (JP); HATANI, Naohisa, Nagaokakyo City, Kyoto 617-8520 (JP); KOBAYASHI, Hitoshi, Nagaokakyo City, Kyoto 617-8520 (JP); MIYAKE, Jiro, Nagaokakyo City, Kyoto 617-8520 (JP); MARUYAMA, Ken, Nagaokakyo City, Kyoto 617-8520 (JP); NAGASAWA, Toshinobu, Nagaokakyo City, Kyoto 617-8520 (JP); OZEKI, Toshiaki, Nagaokakyo City, Kyoto 617-8520 (JP); MORI, Goro, Nagaokakyo City, Kyoto 617-8520 (JP)
(74) Representative: Novagraaf International SA
(86) International application number: PCT/JP2022/009391
(87) International publication number: WO 2022/186376

(57) **Abstract**

A cell stack management system (1) includes a cell monitoring unit (10) that measures an output voltage of a plurality of power storage cells (81), a battery management unit (20) that manages a cell stack (8), and a first communication network (NW1) that connects the cell monitoring unit (10) and the battery management unit (20). The battery management unit (20) includes: a first communication circuit (21) connected to the first communication network (NW1); a second communication circuit (22) connected to a second communication network (NW2) for connecting to a higher-level system (2); a control circuit (23) that controls the battery management unit (20); and a control circuit power supply (33). The cell stack management system (1) includes a normal mode and a low-power mode as modes of operation. During transition from the low-power mode to the normal mode, the first communication circuit (21) activates at least one of the control circuit power supply (33), the control circuit (23), or the second communication circuit (22).

## Description

### [Technical Field]

The present disclosure relates to cell stack management systems.

### [Background Art]

A conventional cell stack management system that monitors the states, such as the voltage and temperature, of a plurality of power storage cells connected in series is known (see, for example, Patent literature (PTL) 1).

The cell stack management system includes a plurality of cell monitoring units that measure power storage cell voltage and a control circuit that controls the plurality of cell monitoring units. The plurality of cell monitoring units and the control circuit are daisy-chained together.

When such a cell stack management system is used in, for example, an in-vehicle power supply, it is necessary to monitor the cell stack with a cell monitoring unit because anomalies can occur even when the vehicle equipped with the cell stack management system is stopped (i.e., even when the batteries are not charged by regenerative energy). For this reason, there are known techniques to operate the cell monitoring unit in a low-power mode to achieve long-term monitoring without having to recharge the battery.

### [Citation List]

### [Patent Literature]

[PTL 1] Japanese Unexamined Patent Application Publication No. 2021-18070

### [Summary of Invention]

### [Technical Problem]

However, even in the low-power mode, power must still be supplied to the control circuit and the like, so there is a need to further reduce power consumption.

The present disclosure overcomes such a problem and has an object to provide a cell stack management system that can inhibit power consumption.

### [Solution to Problem]

In order to overcome the above-described problem, a cell stack management system according to one aspect of the present disclosure manages a cell stack including a plurality of power storage cells connected in series or parallel, and includes: a cell monitoring unit that is connected to the plurality of power storage cells and measures an output voltage of at least one of the plurality of power storage cells; a battery management unit that manages the cell stack; and a first communication network that connects the cell monitoring unit and the battery management unit. The battery management unit includes: a first communication circuit connected to the first communication network; a second communication circuit connected to a second communication network for connecting to a higher-level system of the cell stack management system; a control circuit that controls the battery management unit; and a control circuit power supply that supplies power to the control circuit. The cell stack management system includes, as modes of operation, a normal mode and a low-power mode that consumes less power than the normal mode. In the low-power mode, at least one of the control circuit power supply, the control circuit, or the second communication circuit is deactivated. During transition from the low-power mode to the normal mode, the first communication circuit activates at least one of the control circuit power supply, the control circuit, or the second communication circuit.

In order to overcome the above-described problem, a cell stack management system according to another aspect of the present disclosure manages a cell stack including a plurality of power storage cells connected in series or parallel, and includes: a cell monitoring unit that is connected to the plurality of power storage cells and measures an output voltage of at least one of the plurality of power storage cells; a battery management unit that manages the cell stack; and a first communication network that connects the cell monitoring unit and the battery management unit. The battery management unit includes: a first communication circuit connected to the first communication network; a second communication circuit connected to a second communication network for connecting to a higher-level system of the cell stack management system; and a control circuit that controls the battery management unit. The first communication circuit is connected to a third communication network for connecting to the higher-level system.

### [Advantageous Effects of Invention]

According to the present disclosure, a cell stack management system that can inhibit power consumption can be provided.

### [Brief Description of Drawings]

[FIG. 1]

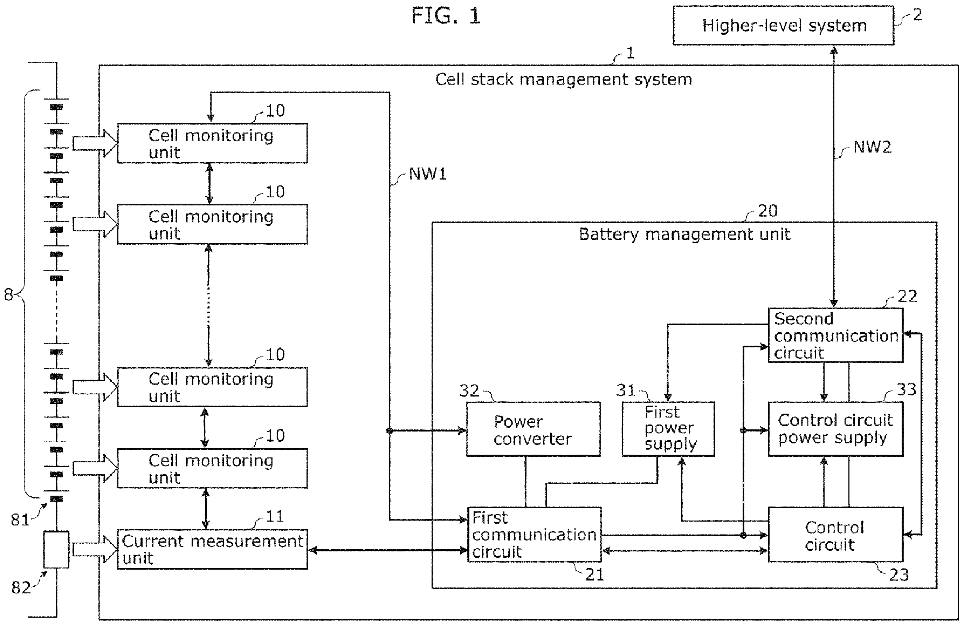

   FIG. 1 is a block diagram illustrating the overall configuration of a cell stack management system according to Embodiment 1.
[FIG. 2]

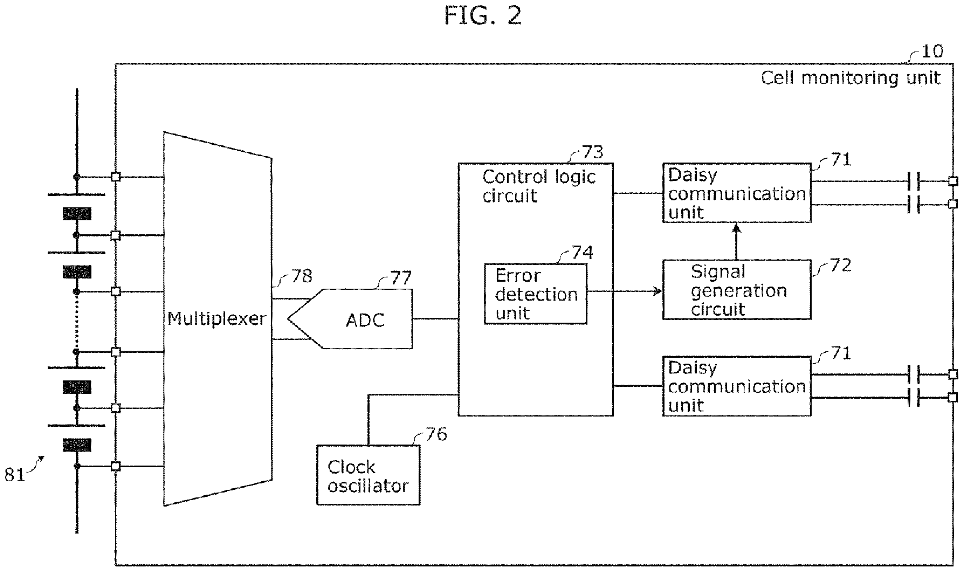

   FIG. 2 is a block diagram illustrating one example of the functional configuration of a cell monitoring unit according to Embodiment 1.
[FIG. 3]

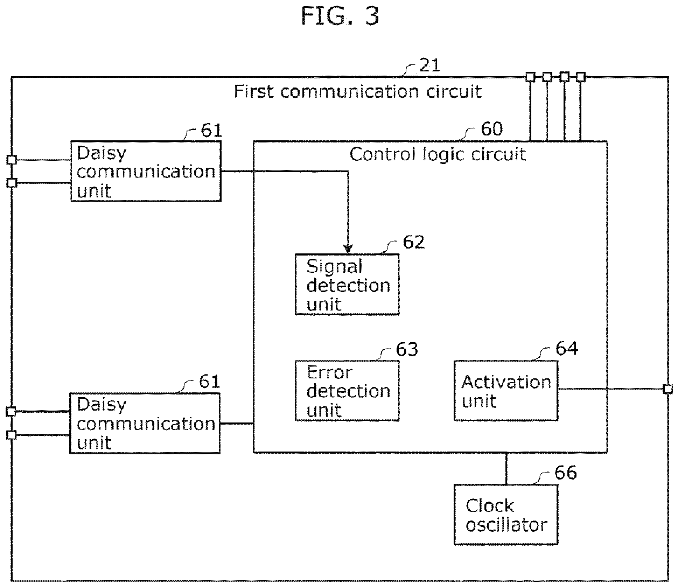

   FIG. 3 is a block diagram illustrating the functional configuration of a first communication circuit according to Embodiment 1.
[FIG. 4]

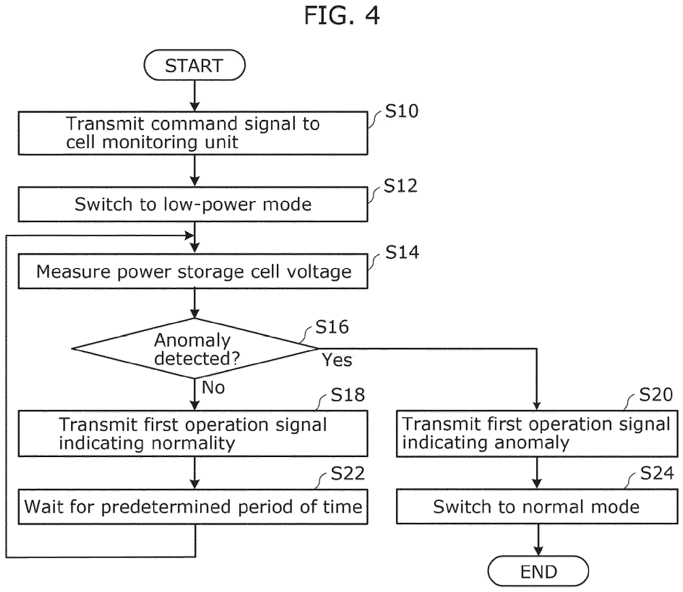

   FIG. 4 is a flowchart illustrating operations performed when switching the cell stack management system according to Embodiment 1 from a normal mode to a low-power mode.
[FIG. 5]

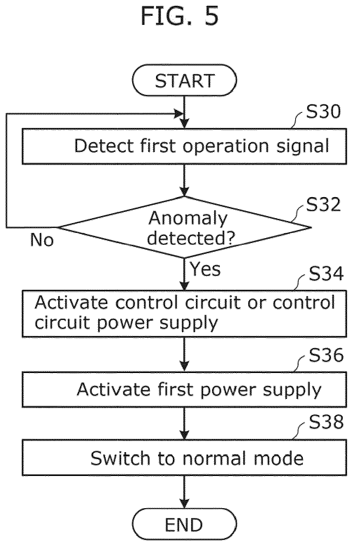

   FIG. 5 is a flowchart illustrating operations performed by the first communication circuit according to Embodiment 1 in the low-power mode.
[FIG. 6]

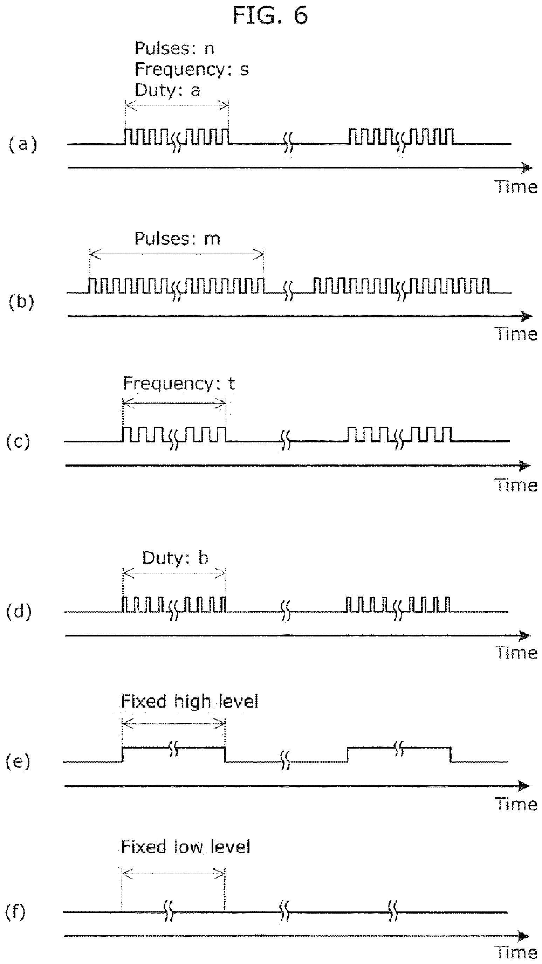

   FIG. 6 illustrates graphs of examples of the time waveform of a first operation signal indicating normality and a first operation signal indicating an anomaly according to Embodiment 1.
[FIG. 7]

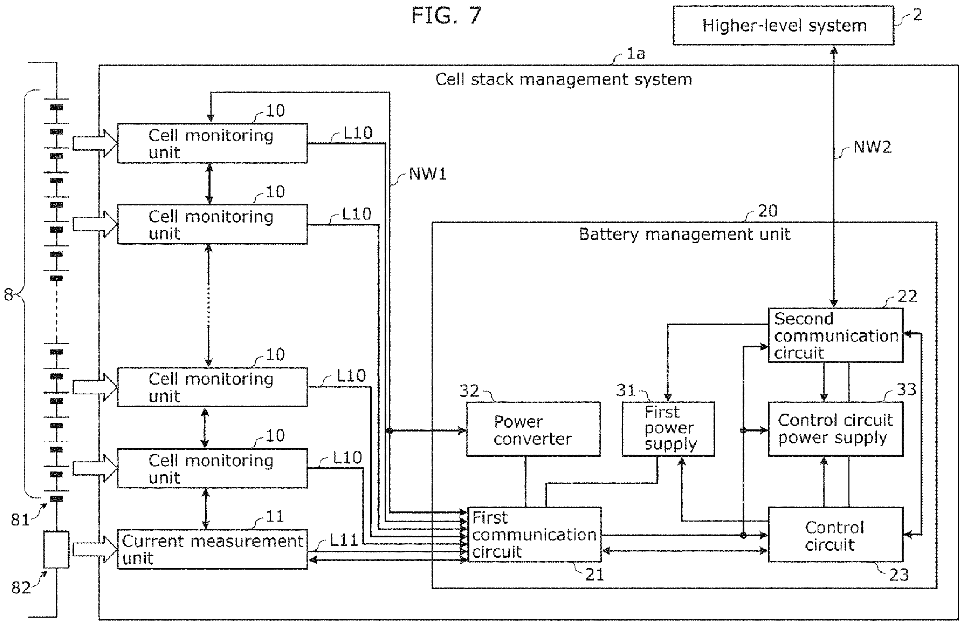

   FIG. 7 is a block diagram illustrating the overall configuration of a cell stack management system according to a variation of Embodiment 1.
[FIG. 8]

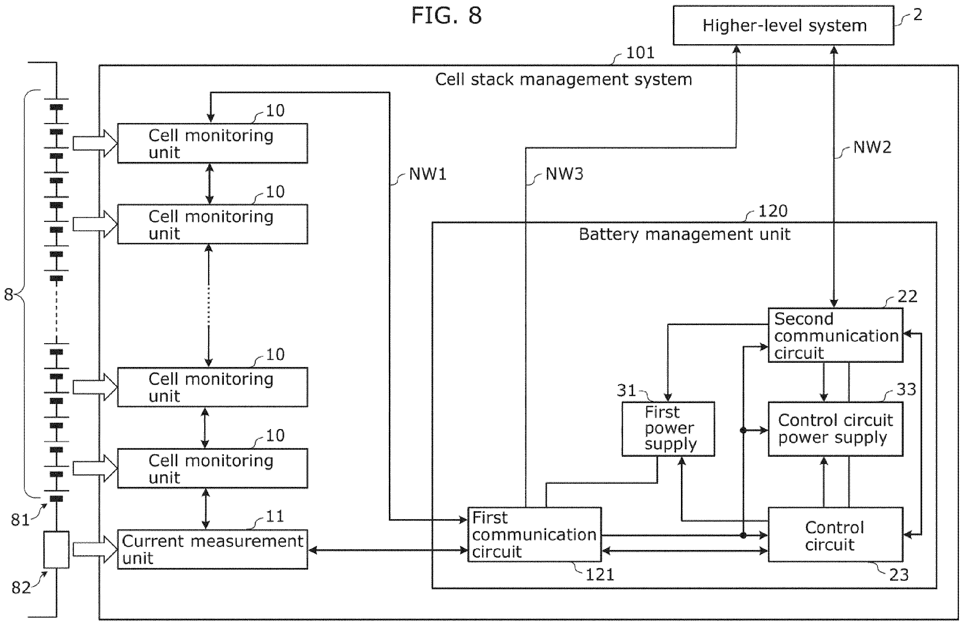

   FIG. 8 is a block diagram illustrating the overall configuration of a cell stack management system according to Embodiment 2.
[FIG. 9]

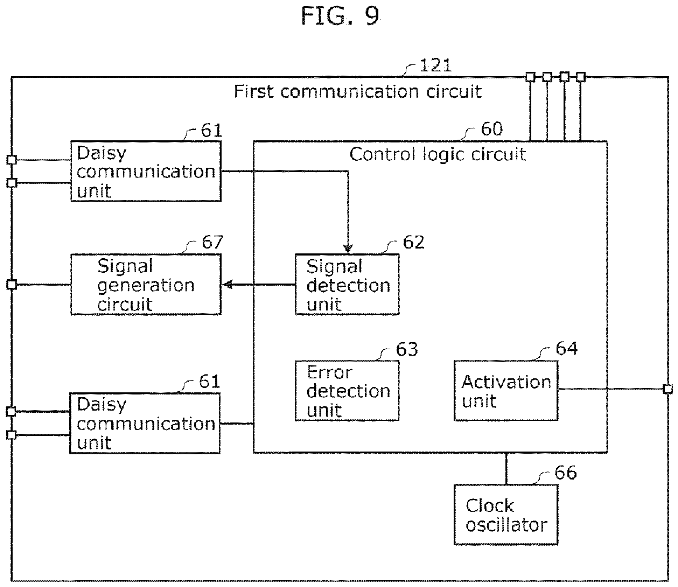

   FIG. 9 is a block diagram illustrating the functional configuration of a first communication circuit according to Embodiment 2.
[FIG. 10]

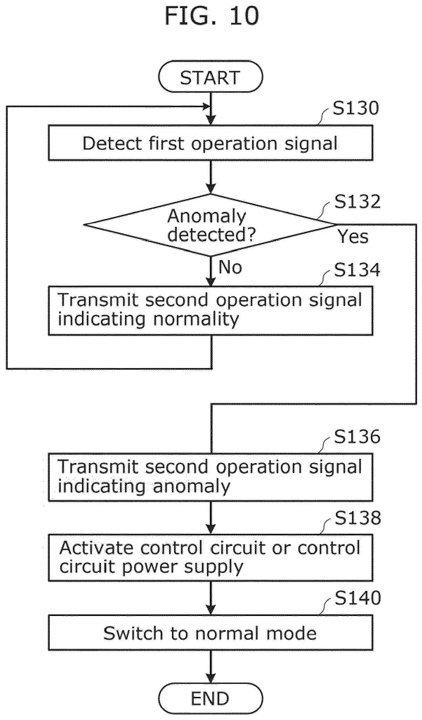

   FIG. 10 is a flowchart illustrating operations performed by the first communication circuit and a higher-level system according to Embodiment 2 in the low-power mode.
[FIG. 11]

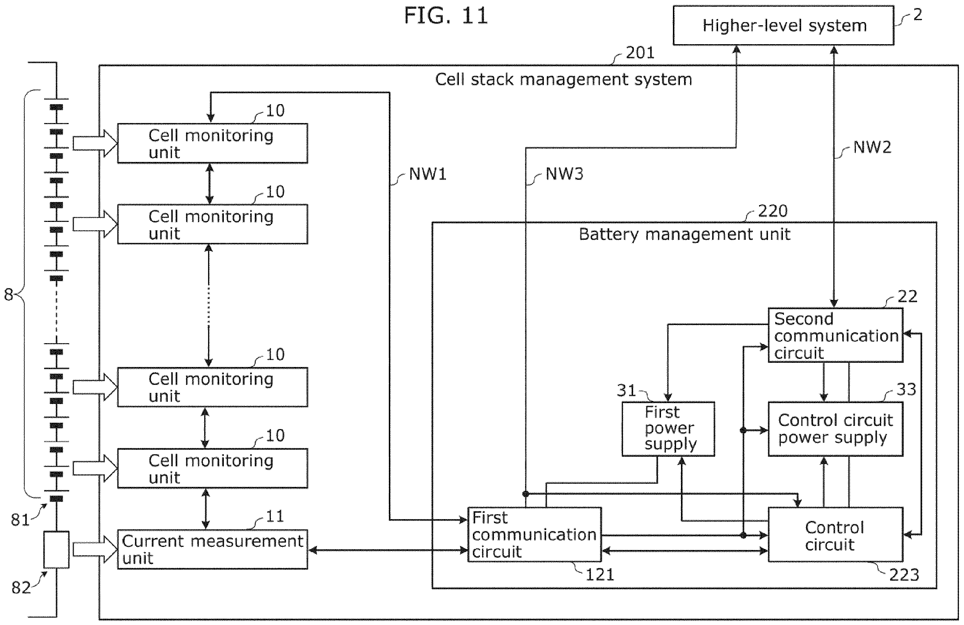

   FIG. 11 is a block diagram illustrating the overall configuration of a cell stack management system according to Embodiment 3.
[FIG. 12]

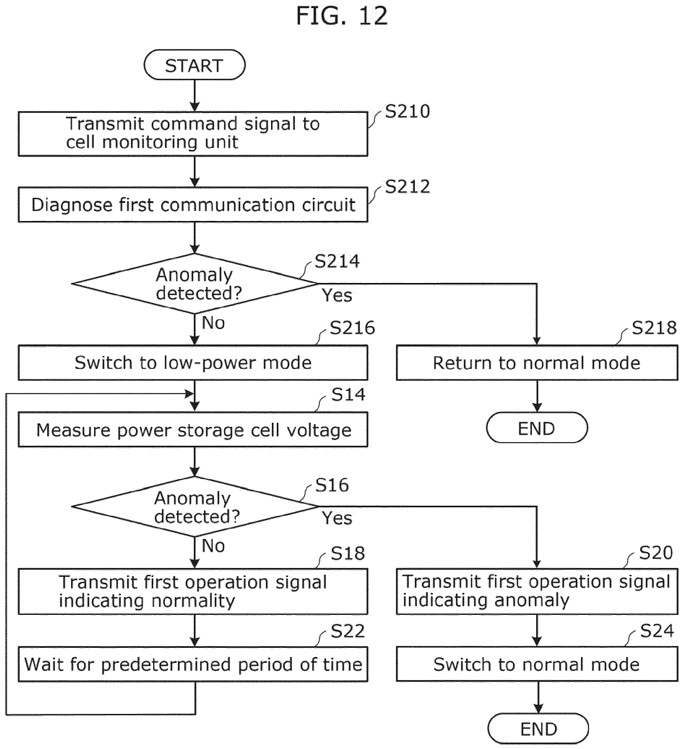

   FIG. 12 is a flowchart illustrating operations performed when switching the cell stack management system according to Embodiment 3 from the normal mode to the low-power mode.
[FIG. 13]

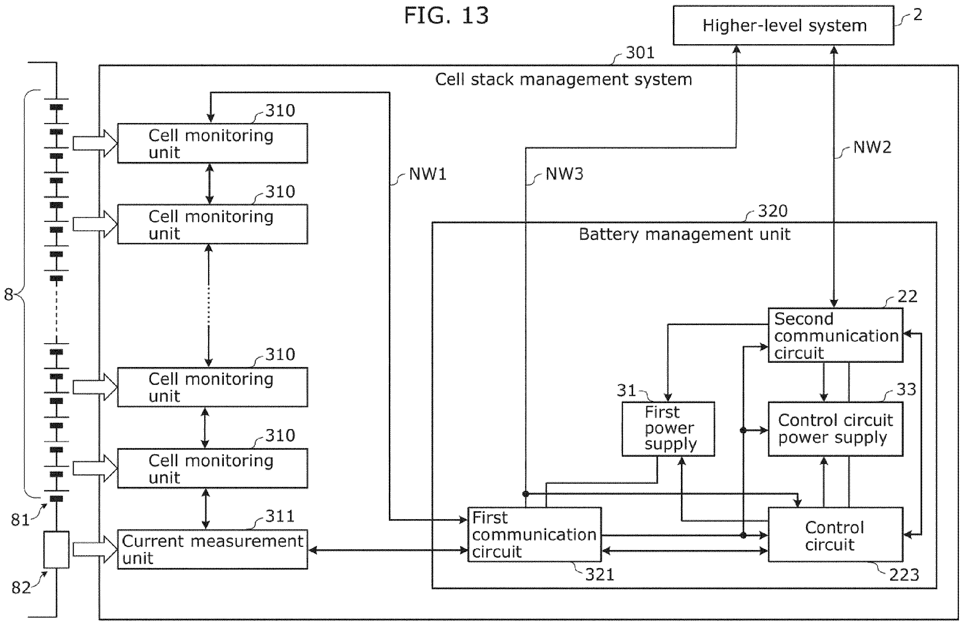

   FIG. 13 is a block diagram illustrating the overall configuration of a cell stack management system according to Embodiment 4.
[FIG. 14]

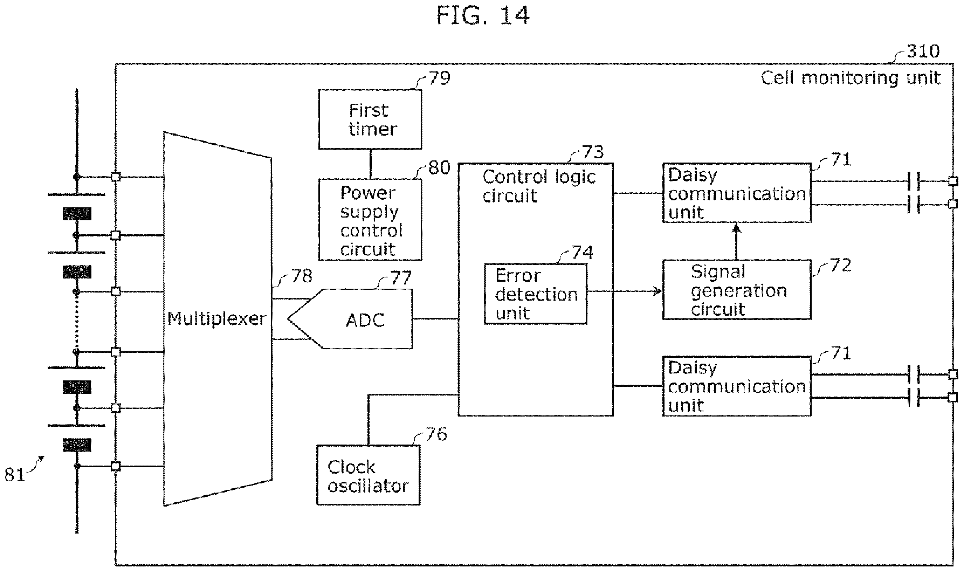

   FIG. 14 is a block diagram illustrating one example of the functional configuration of a cell monitoring unit according to Embodiment 4.
[FIG. 15]

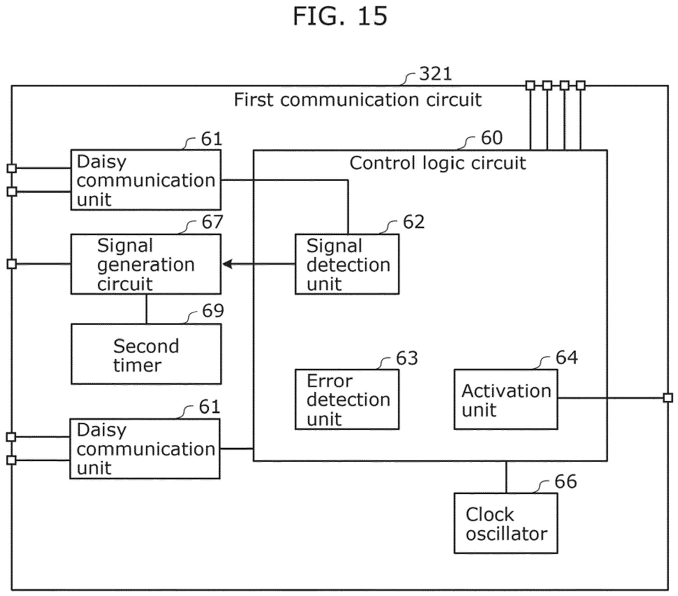

   FIG. 15 is a block diagram illustrating the functional configuration of a first communication circuit according to Embodiment 4.

### [Description of Embodiments]

Hereinafter, embodiments of the present disclosure will be described with reference to the drawings. Each of the following embodiments shows a specific example of the present disclosure. The numerical values, shapes, materials, elements, the arrangement and connection of the elements, etc., indicated in the following embodiments are mere examples, and therefore do not intend to limit the present disclosure.

The figures are schematic illustrations and are not necessarily precise depictions. Accordingly, the figures are not necessarily to scale. Elements that are essentially the same share like reference signs in the figures, and duplicate description is omitted or simplified.

### [Embodiment 1]

Cell stack management system according to Embodiment 1 will be described.

### [1-1. Overall Configuration]

The overall configuration of the cell stack management system according to the present embodiment will be described with reference to FIG. 1. FIG. 1 is a block diagram illustrating the overall configuration of cell stack management system 1 according to the present embodiment. FIG. 1 also illustrates cell stack 8 that is managed by cell stack management system 1, as well as higher-level system 2 of cell stack management system 1.

Higher-level system 2 is a system that controls cell stack management system 1. For example, when cell stack management system 1 is used for in-vehicle power supply, higher-level system 2 is, for example, an electric control unit (ECU).

Cell stack management system 1 is a system that manages cell stack 8 including a plurality of power storage cells 81 connected in series or parallel. Cell stack management system 1 includes, as modes of operation, a normal mode and a low-power mode that consumes less power than the normal mode. As illustrated in FIG. 1, cell stack management system 1 includes battery management unit 20, a plurality of cell monitoring units 10, current measurement unit 11, first communication network NW1, and second communication network NW2.

In the present embodiment, cell stack 8 includes a plurality of power storage cells 81 connected in series. Resistor element 82 for current measurement is connected in series with cell stack 8. For example, a lithium-ion battery can be used as power storage cell 81.

The plurality of cell monitoring units 10 are daisy-chained together along with current measurement unit 11. This daisy communication path is first communication network NW1. First communication network NW1 connects the plurality of cell monitoring units 10 and battery management unit 20.

Second communication network NW2 is a communication network for connecting to higher-level system 2. For example, a communication network based on the controller area network (CAN) standard can be used as second communication network NW2.

Each of the plurality of cell monitoring units 10 is a unit that is connected to the plurality of power storage cells 81 and measures the output voltage of at least one of the plurality of power storage cells 81. Cell monitoring units 10 transmit first operation signals indicating states of the plurality of power storage cells 81 to first communication circuit 21 of battery management unit 20. In the low-power mode, when control circuit 23 or second communication circuit 22 is deactivated, the first operation signal transmitted by cell monitoring unit 10 is a repeating pulse signal. The first operation signal functions as a so-called heartbeat signal. Having detected the first operation signal, first communication circuit 21 of battery management unit 20 can detect that cell monitoring unit 10 is operating normally. If cell monitoring unit 10 detects an anomaly in, for example, power storage cell 81, it transmits a first operation signal indicating the anomaly. Details regarding the first operation signal will be described later.

A configuration example of cell monitoring unit 10 will be described with reference to FIG. 2. FIG. 2 is a block diagram illustrating one example of the functional configuration of cell monitoring unit 10 according to the present embodiment.

As illustrated in FIG. 2, cell monitoring unit 10 includes a pair of daisy communication units 71, signal generation circuit 72, control logic circuit 73, clock oscillator 76, analog-to-digital converter (ADC) 77, and multiplexer 78.

Daisy communication units 71 are communication units that performs daisy communication. Daisy communication units 71 are connected to first communication network NW1 via isolation elements such as capacitors and transformers.

Signal generation circuit 72 is a circuit that generates the first operation signal.

ADC 77 is a circuit that measures the voltage of power storage cells 81. ADC 77 converts the measured voltage values into digital signals and outputs them to control logic circuit 73.

Multiplexer 78 is a circuit that switches power storage cells 81 to be measured by ADC 77. Note that the configuration of cell monitoring unit 10 is not limited to this example. For example, cell monitoring unit 10 may include just as many ADCs 77 as there are power storage cells 81, i.e., measurement targets.

Control logic circuit 73 is a circuit that controls cell monitoring unit 10. Control logic circuit 73 monitors power storage cells 81 based on measurement values, etc., input from ADC 77. Control logic circuit 73 also includes error detection unit 74 that detects, for example, an anomaly in power storage cell 81. Control logic circuit 73 causes signal generation circuit 72 to generate a first operation signal indicating the detected anomaly. Control logic circuit 73 transmits and receives signals via daisy communication units 71 and first communication network NW1.

Clock oscillator 76 is an oscillator that outputs a clock signal for operating control logic circuit 73.

Current measurement unit 11 measures the voltage between both ends of resistor element 82 that is connected in series to cell stack 8. Current measurement unit 11 can be realized, for example, by the same configuration as cell monitoring unit 10.

Battery management unit 20 is a unit that manages cell stack 8. Battery management unit 20 includes first communication circuit 21, second communication circuit 22, control circuit 23, first power supply 31, control circuit power supply 33, and power converter 32.

Control circuit 23 is a circuit that controls battery management unit 20. Control circuit 23 can be realized using, for example, a micro-controller unit (MCU). Control circuit 23 controls first communication circuit 21 and the like in the normal mode, and is deactivated in the low-power mode. With this, cell stack management system 1 can inhibit power consumption in the low-power mode.

Control circuit power supply 33 is a power supply that supplies power to control circuit 23. In the present embodiment, control circuit power supply 33 also supplies power to second communication circuit 22. In this way, the element to which control circuit power supply 33 supplies power is not limited to control circuit 23. For example, a low-dropout (LDO) regulator can be used as control circuit power supply 33. In the present embodiment, control circuit power supply 33 is deactivated in the low-power mode. With this, cell stack management system 1 can inhibit power consumption in the low-power mode.

First power supply 31 is a power supply that supplies power to first communication circuit 21. For example, an LDO regulator can be used as first power supply 31.

First communication circuit 21 is a circuit connected to first communication network NW1. First communication circuit 21 receives a first operation signal indicating the state of the plurality of power storage cells 81 from the plurality of cell monitoring units 10 connected to first communication network NW1. First communication circuit 21 is controlled by control circuit 23 in the normal mode. First communication circuit 21 detects the first operation signal from first communication network NW1 in the low-power mode. During the transition from the low-power mode to the normal mode, first communication circuit 21 activates at least one of deactivated control circuit power supply 33, control circuit 23, or second communication circuit 22 based on the first operation signal.

A configuration example of first communication circuit 21 will be described with reference to FIG. 3. FIG. 3 is a block diagram illustrating the functional configuration of first communication circuit 21 according to the present embodiment. As illustrated in FIG. 3, first communication circuit 21 includes a pair of daisy communication units 61, control logic circuit 60, and clock oscillator 66.

Daisy communication units 61 are communication units that perform daisy communication. Daisy communication units 61 may be connected to first communication network NW1 via isolation elements such as capacitors and transformers.

Control logic circuit 60 is a circuit that controls first communication circuit 21. Control logic circuit 60 detects signals from the plurality of cell monitoring units 10 and current measurement unit 11 input from daisy communication units 61, and controls first communication circuit 21. For example, control logic circuit 60 includes signal detection unit 62, error detection unit 63, and activation unit 64. Signal detection unit 62 detects signals from first communication network NW1. For example, signal detection unit 62 detects the first operation signals from cell monitoring units 10.

Error detection unit 63 detects anomalies in power storage cells 81 and the like based on signals detected by signal detection unit 62.

Activation unit 64 activates first communication circuit 21 based on an external activation signal.

Clock oscillator 66 is an oscillator that outputs a clock signal for operating control logic circuit 60.

Second communication circuit 22 is a circuit connected to second communication network NW2 for connecting to higher-level system 2 of cell stack management system 1. For example, second communication circuit 22 includes a CAN interface. In the present embodiment, second communication circuit 22 is supplied with power from control circuit power supply 33. Second communication circuit 22 is also supplied with power from a power supply other than control circuit power supply 33, allowing it to activate and operate even when control circuit power supply 33 is deactivated.

Power converter 32 is a converter that supplies power to first communication circuit 21. Power converter 32 converts signals transmitted in first communication network NW1 to DC power, and supplies the DC power to first communication circuit 21.

### [1-2. Operations]

Operations performed by cell stack management system 1 according to the present embodiment will be described with reference to FIG. 4. FIG. 4 is a flowchart illustrating operations performed when switching cell stack management system 1 according to the present embodiment from the normal mode to the low-power mode. FIG. 5 is a flowchart illustrating operations performed by first communication circuit 21 according to the present embodiment in the low-power mode.

As illustrated in FIG. 4, before switching from the normal mode to the low-power mode, first communication circuit 21 of battery management unit 20 first transmits a command signal (i.e., a communication command) to cell monitoring unit 10 (and current measurement unit 11) (S10). This makes it possible to set, for example, the voltage measurement method and the measurement cycle for cell monitoring unit 10 in the low-power mode. The measurement cycle in the low-power mode is longer than the measurement cycle in the normal mode. Stated differently, cell monitoring unit 10 performs intermittent measurements in the low-power mode. For example, switching from the normal mode to the low-power mode is initiated based on a command signal that is transmitted from higher-level system 2 to second communication circuit 22 via second communication network NW2 and instructs second communication circuit 22 to switch to the low-power mode.

Next, control circuit 23 switches the mode of operation of cell stack management system 1 to the low-power mode (S12). More specifically, control circuit 23 deactivates second communication circuit 22. Control circuit 23 deactivates second communication circuit 22 by transmitting a deactivation signal to second communication circuit 22. Control circuit 23 also deactivates itself by shutting down control circuit power supply 33, which supplies power to control circuit 23. In this way, in the low-power mode, the power consumption of cell stack management system 1 can be inhibited by not only causing cell monitoring unit 10 perform intermittent measurements, but also by deactivating control circuit 23, control circuit power supply 33 and second communication circuit 22.

Note that the state of first communication circuit 21 may be diagnosed before control circuit 23 is deactivated as described above. In the present embodiment, it is first communication circuit 21 that effectively controls cell stack management system 1 in the low-power mode. Accordingly, if the mode of operation is switched to the low-power mode when there is an anomaly in first communication circuit 21, a serious problem could occur, such as an inability to detect an anomaly in cell stack management system 1. Therefore, diagnosing first communication circuit 21 before control circuit 23 deactivates can reduce the occurrence of problems with cell stack management system 1 in the low-power mode. More specifically, before control circuit 23 deactivates, first communication circuit 21 outputs a control activation signal to control circuit 23 for activating control circuit 23. Control circuit 23 diagnoses the state of first communication circuit 21 based on the control activation signal. Stated differently, it diagnoses whether the output control activation signal is capable of activating control circuit 23.

Since the states of power storage cells 81 must continue to be monitored even in the low-power mode, first communication circuit 21 monitors the states of power storage cells 81 and cell monitoring units 10 using the first operation signal from cell monitoring units 10. Since operations in first communication circuit 21 are limited in the low-power mode, the power supplied by first power supply 31 can be inhibited. Battery management unit 20 includes a function for deactivating first power supply 31 in the low-power mode. For example, control circuit 23 deactivates first power supply 31. When first power supply 31 is deactivated, signals transmitted in first communication network NW1 are converted to DC power and the DC power is supplied to first communication circuit 21. In the present embodiment, power converter 32 converts the first operation signal to DC power.

Thus, by deactivating first power supply 31, the power consumption of cell stack management system 1 in the low-power mode can be further inhibited.

Next, cell monitoring unit 10 measures the voltage of power storage cell 81 (S14).

Next, cell monitoring unit 10 determines whether or not an anomaly has been detected in, for example, power storage cell 81 based on, for example, the measurement result (S16). If cell monitoring unit 10 does not detect an anomaly (No in S16), it transmits a first operation signal indicating normality to first communication network NW1 (S18). However, if cell monitoring unit 10 does detect an anomaly (Yes in S16), it transmits a first operation signal indicating the anomaly to first communication network NW1 (S20). Stated differently, if at least one of control circuit power supply 33, control circuit 23, or second communication circuit 22 is deactivated and cell monitoring unit 10 detects an anomaly, cell monitoring unit 10 outputs a first operation signal indicating an anomaly.

The first operation signal indicating normality or an anomaly will be described with reference to FIG. 6. FIG. 6 illustrates graphs of examples of the time waveform of the first operation signal indicating normality and the first operation signal indicating an anomaly according to the present embodiment. Graph (a) in FIG. 6 illustrates one example of a first operation signal indicating normality, and each of graphs (b) through (f) illustrates one example of a first operation signal indicating an anomaly.

As illustrated in graph (a) in FIG. 6, when the number of repeating pulses of the first operation signal indicating normality is expressed as "n", the frequency is expressed as "s", and the duty cycle is expressed as "a", a first operation signal indicating an anomaly may be a signal that is distinguishable from a first operation signal indicating normality. For example, a first operation signal indicating an anomaly may have a different number of pulses ("m") than a first operating frequency indicating normality, as illustrated in graph (b). For example, a first operation signal indicating an anomaly may have a different frequency ("t") than a first operating frequency indicating normality, as illustrated in graph (c). For example, a first operation signal indicating an anomaly may have a different duty ("b") than a first operating frequency indicating normality, as illustrated in graph (d). Furthermore, as illustrated in graph (e), a first operation signal indicating an anomaly may be a signal fixed at a high level over a predetermined period of time. Similarly, as illustrated in graph (f), a first operation signal indicating an anomaly may be a signal fixed at a low level over a predetermined period of time. In other words, a signal need not be output. In the present disclosure, aspects in which a signal is not output are included in examples of a first operation signal indicating an anomaly.

Returning to FIG. 4, if cell monitoring unit 10 outputs a first operation signal indicating normality in step S18, cell monitoring unit 10 waits for a predetermined period of time (S22). Stated differently, cell monitoring unit 10 waits for a predetermined period of time without measuring the voltage of power storage cell 81.

Next, after waiting for a predetermined period of time, cell monitoring unit 10 returns to step S14.

However, if cell monitoring unit 10 outputs a first operation signal indicating an anomaly in step S20, cell stack management system 1 is switched to the normal mode (S24). This ends the low-power mode.

Here, operations performed by first communication circuit 21 in the low-power mode will be described with reference to FIG. 5. These operations include the operation of step S24 in FIG. 4.

As illustrated in FIG. 5, first communication circuit 21 detects a first operation signal from first communication network NW1 (S30).

Next, first communication circuit 21 determines whether or not an anomaly is detected based on the first operation signal (S32). More specifically, first communication circuit 21 determines whether the first operation signal is a signal indicating an anomaly such as those illustrated in FIG. 6. If first communication circuit 21 does not detect an anomaly (No in S32), processing returns to step S30. However, if first communication circuit 21 does detect an anomaly (Yes in S32), first communication circuit 21 activates control circuit 23 or control circuit power supply 33 (S34). For example, first communication circuit 21 activates control circuit power supply 33 by transmitting an activation signal to control circuit power supply 33 (S36). With this, control circuit power supply 33 starts supplying power to control circuit 23, which activates control circuit 23. Activating control circuit 23 by activating control circuit power supply 33 in this manner is also referred to as simply activating control circuit 23. In step S34, first communication circuit 21 may also activate second communication circuit 22, or activated control circuit 23 may activate second communication circuit 22. In the present embodiment, first communication circuit 21 may activate first power supply 31 and stop the output of DC power of power converter 32. This removes the limitations on operations in accordance with the DC power of power converter 32 in first communication circuit 21.

First communication circuit 21 may activate second communication circuit 22, which is deactivated in the low-power mode. When second communication circuit 22 is activated by first communication circuit 21, second communication circuit 22 notifies higher-level system 2, via second communication network NW2, of the activation of second communication circuit 22. Upon receiving the notification, higher-level system 2 may activate control circuit power supply 33 and control circuit 23 via second communication network NW2. In this way, control circuit power supply 33 may be activated by higher-level system 2.

Next, the mode of operation of cell stack management system 1 is switched to the normal mode (S38). More specifically, first communication circuit 21 transmits a command signal to cell monitoring unit 10 (and current measurement unit 11). This switches the mode of operation of cell monitoring unit 10 to the normal mode.

As described above, the mode of operation can be switched in cell stack management system 1. In the present embodiment, since control circuit 23, control circuit power supply 33, first power supply 31, and second communication circuit 22 are deactivated in the low-power mode, power consumption is inhibited. Even in such a low-power mode, power storage cells 81 can be reliably monitored, and if an anomaly is detected, first communication circuit 21 can quickly switch to the normal mode.

### [1-3. Variation]

A variation of cell stack management system 1 according to the present embodiment will be described with reference to FIG. 7. FIG. 7 is a block diagram illustrating the overall configuration of cell stack management system 1a according to a variation of the present embodiment.

As illustrated in FIG. 7, cell stack management system 1a according to the present variation includes individual communication lines L10 directly connecting each of cell monitoring units 10 to first communication circuit 21, and individual communication line L11 directly connecting current measurement unit 11 to first communication circuit 21. In this configuration, first communication circuit 21 may detect signals indicating anomalies from these individual communication lines L10 and L11.

### [Embodiment 2]

Cell stack management system according to Embodiment 2 will be described. The cell stack management system according to the present embodiment differs from cell stack management system 1 according to Embodiment 1 mainly in that the first communication circuit includes a third communication network for connecting to a higher-level system. Hereinafter, the cell stack management system according to the present embodiment will be described focusing on the points of difference from cell stack management system 1 according to Embodiment 1.

### [2-1. Overall Configuration]

The overall configuration of the cell stack management system according to the present embodiment will be described with reference to FIG. 8. FIG. 8 is a block diagram illustrating the overall configuration of cell stack management system 101 according to the present embodiment. As illustrated in FIG. 8, cell stack management system 101 includes battery management unit 120, a plurality of cell monitoring units 10, current measurement unit 11, first communication network NW1, second communication network NW2, and third communication network NW3.

Third communication network NW3 is a communication network for connecting to higher-level system 2.

Battery management unit 120 according to the present embodiment includes first communication circuit 121, second communication circuit 22, control circuit 23, first power supply 31, and control circuit power supply 33.

First communication circuit 121 according to the present embodiment is connected to third communication network NW3, which is for connecting to higher-level system 2. When control circuit 23 or second communication circuit 22 cannot communicate, first communication circuit 121 communicates with higher-level system 2 via third communication network NW3.

Here, a configuration example of first communication circuit 121 will be described with reference to FIG. 9. FIG. 9 is a block diagram illustrating the functional configuration of first communication circuit 121 according to the present embodiment. As illustrated in FIG. 9, first communication circuit 121 includes a pair of daisy communication units 61, control logic circuit 60, clock oscillator 66, and signal generation circuit 67.

Signal generation circuit 67 is a circuit that generates a second operation signal. Signal generation circuit 67 generates a second operation signal based on a first operation signal detected by signal detection unit 62 of control logic circuit 60, and transmits the second operation signal to third communication network NW3.

In the present embodiment, just as in Embodiment 1, when at least one of control circuit power supply 33, control circuit 23, or second communication circuit 22 is deactivated (i.e., in the low-power mode), cell monitoring unit 10 transmits a first operation signal to first communication circuit 121. First communication circuit 121 transmits, via third communication network NW3, a second operation signal indicating that cell monitoring unit 10 and first communication circuit 121 are in operation. The second operation signal is a signal including the same information as the first operation signal. The time waveform and other aspects of the second operation signal are not particularly limited. The second operation signal may be the same signal as the first operation signal.

In the present embodiment as well, just as in Embodiment 1, if at least one of control circuit power supply 33, control circuit 23, or second communication circuit 22 is deactivated and cell monitoring unit 10 detects an anomaly, cell monitoring unit 10 outputs a first operation signal indicating an anomaly. When first communication circuit 121 receives a first operation signal indicating an anomaly from first communication network NW1, first communication circuit 121 outputs a second operation signal indicating an anomaly.

Note that when control circuit 23 or second communication circuit 22 are deactivated and the first operation signal is stopped, and when control circuit 23 or second communication circuit 22 are deactivated and there is an anomaly in first communication circuit 121, first communication circuit 121 may stop transmitting the second operation signal. This allows higher-level system 2 to detect that there is an anomaly in at least one of the first operation signal or first communication circuit 121. In such a case, control circuit 23 or second communication circuit 22 is activated via second communication network NW2. This allows control circuit 23 to handle anomalies appropriately.

### [2-2. Operations]

Operations performed by cell stack management system 101 according to the present embodiment will be described with reference to FIG. 10. FIG. 10 is a flowchart illustrating operations performed by first communication circuit 121 and higher-level system 2 according to the present embodiment in the low-power mode.

The operations performed by cell stack management system 101 according to the present embodiment are the same as those of cell stack management system 1 according to Embodiment 1 up until the step where cell monitoring unit 10 outputs the first operation signal (step S22 and step S24 illustrated in FIG. 4). Therefore, the following will describe the operations after the step where first communication circuit 121 detects the first operation signal. In the present embodiment, communication via third communication network NW3 between first communication circuit 121 and higher-level system 2 is initiated when the system is switched to the low-power mode.

As illustrated in FIG. 10, first communication circuit 121 detects a first operation signal from first communication network NW1 (S130).

Next, first communication circuit 121 determines whether or not an anomaly is detected based on the first operation signal (S132). If first communication circuit 121 does not detect an anomaly (No in S132), first communication circuit 121 transmits a second operation signal indicating normality to higher-level system 2 via third communication network NW3 (S134), and returns to step S130.

However, if first communication circuit 121 does detect an anomaly (Yes in S132), first communication circuit 121 transmits a second operation signal indicating the anomaly to higher-level system 2 via third communication network NW3 (S136). Upon receiving this second operation signal, higher-level system 2 causes second communication circuit 22 to activate control circuit 23 or control circuit power supply 33 via second communication network NW2 (S138).

Next, the mode of operation of cell stack management system 101 is switched to the normal mode (S140). More specifically, first communication circuit 121 transmits a command signal to cell monitoring unit 10 (and current measurement unit 11). This switches the mode of operation of cell monitoring unit 10 to the normal mode.

As described above, the mode of operation can be switched in cell stack management system 101. In the present embodiment, since control circuit 23, control circuit power supply 33, and second communication circuit 22 are deactivated in the low-power mode, power consumption is inhibited. Even in such a low-power mode, power storage cells 81 can be reliably monitored, and if an anomaly is detected, first communication circuit 121 can quickly switch to the normal mode.

### [Embodiment 3]

Cell stack management system according to Embodiment 3 will be described. The cell stack management system according to the present embodiment differs from cell stack management system 101 according to Embodiment 2 mainly in that the first communication circuit transmits a second operation signal not only to higher-level system 2 but also to control circuit 23. Hereinafter, the cell stack management system according to the present embodiment will be described focusing on the points of difference from cell stack management system 101 according to Embodiment 2.

### [3-1. Overall Configuration]

The overall configuration of the cell stack management system according to the present embodiment will be described with reference to FIG. 11. FIG. 11 is a block diagram illustrating the overall configuration of cell stack management system 201 according to the present embodiment. As illustrated in FIG. 11, cell stack management system 201 includes battery management unit 220, a plurality of cell monitoring units 10, current measurement unit 11, first communication network NW1, second communication network NW2, and third communication network NW3.

Battery management unit 220 according to the present embodiment includes first communication circuit 121, second communication circuit 22, control circuit 223, first power supply 31, and control circuit power supply 33.

Control circuit 223 receives the second operation signal from first communication circuit 121 via third communication network NW3. Before deactivating, control circuit 223 diagnoses the state of first communication circuit 121 based on the second operation signal.

### [3-2. Operations]

Operations performed by cell stack management system 201 according to the present embodiment will be described with reference to FIG. 12. FIG. 12 is a flowchart illustrating operations performed when switching cell stack management system 201 according to the present embodiment from the normal mode to the low-power mode.

As illustrated in FIG. 12, first, before switching from the normal mode to the low-power mode, first communication circuit 121 of battery management unit 220 transmits a command signal to cell monitoring unit 10 (and current measurement unit 11) (S210), just as in the operations performed by cell stack management system 1 according to Embodiment 1.

Next, before deactivating, control circuit 223 diagnoses first communication circuit 121 (S212), and determines whether an anomaly is detected in first communication circuit 121 (S214). More specifically, before control circuit 223 deactivates, first communication circuit 121 outputs the second operation signal to control circuit 223 or higher-level system 2 via third communication network NW3. Control circuit 223 or higher-level system 2 diagnoses the state of first communication circuit 121 based on the second operation signal. If no anomaly is detected in first communication circuit 121 as a result of the diagnosis (No in S214), cell stack management system 201 switches the mode of operation to the low-power mode (S216).

However, if an anomaly is detected in first communication circuit 121 as a result of the diagnosis (Yes in S214), cell stack management system 201 returns the mode of operation to the normal mode (S218). More specifically, cell stack management system 201 returns to the normal by, for example, control circuit 223 transmitting a command signal to cell monitoring unit 10.

When the mode of operation of cell stack management system 201 is switched to the low-power mode, cell stack management system 201 performs the same operations as in steps S14 through S24 performed by cell stack management system 1 according to Embodiment 1. The operations for switching from the low-power mode to the normal mode performed by cell stack management system 201 are the same as the operations performed by cell stack management system 101 according to Embodiment 2.

The same effects are achieved in cell stack management system 201 according to the present embodiment as in cell stack management system 101 according to Embodiment 2.

### [Embodiment 4]

Cell stack management system according to Embodiment 4 will be described. The cell stack management system according to the present embodiment differs from cell stack management system 201 according to Embodiment 3 mainly in that the first communication circuit and the like change aspects of signals generated based on a timer. Hereinafter, the cell stack management system according to the present embodiment will be described focusing on the points of difference from cell stack management system 201 according to Embodiment 3.

### [4-1. Overall Configuration]

The overall configuration of the cell stack management system according to the present embodiment will be described with reference to FIG. 13. FIG. 13 is a block diagram illustrating the overall configuration of cell stack management system 301 according to the present embodiment. As illustrated in FIG. 13, cell stack management system 301 includes battery management unit 320, a plurality of cell monitoring units 310, current measurement unit 311, first communication network NW1, second communication network NW2, and third communication network NW3.

Battery management unit 320 according to the present embodiment includes first communication circuit 321, second communication circuit 22, control circuit 223, first power supply 31, and control circuit power supply 33.

Cell monitoring unit 310 according to the present embodiment will be described with reference to FIG. 14. FIG. 14 is a block diagram illustrating one example of the functional configuration of cell monitoring unit 310 according to the present embodiment.

As illustrated in FIG. 14, cell monitoring unit 310 includes a pair of daisy communication units 71, signal generation circuit 72, control logic circuit 73, clock oscillator 76, ADC 77, multiplexer 78, first timer 79, and power supply control circuit 80.

Power supply control circuit 80 is a circuit that controls the supply of power from the power supply of cell monitoring unit 310.

First timer 79 is a circuit that measures time and causes power supply control circuit 80 to stop supplying power to cell monitoring unit 310 when it detects that a preset first time has elapsed. Stated differently, first timer 79 stops the operation of cell monitoring unit 310 when it detects that a preset first time has elapsed.

Note that current measurement unit 311 has the same configuration as cell monitoring unit 310.

First communication circuit 321 according to the present embodiment will be described with reference to FIG. 15. FIG. 15 is a block diagram illustrating the functional configuration of first communication circuit 321 according to the present embodiment. As illustrated in FIG. 15, first communication circuit 321 includes a pair of daisy communication units 61, control logic circuit 60, clock oscillator 66, signal generation circuit 67, and second timer 69.

Second timer 69 is a circuit that measures time and causes signal generation circuit 67 to stop generating the second operation signal when it detects that a preset second time has elapsed.

### [4-2. Operations]

As described above, in the low-power mode, first timer 79 of cell monitoring unit 310 of cell stack management system 301 according to the present embodiment causes power supply control circuit 80 to stop supplying power to cell monitoring unit 310 when it detects that a first time has elapsed. Stated differently, first timer 79 stops the operation of cell monitoring unit 310 when it detects that a preset first time has elapsed. This stops the output of the first operation signal. First communication circuit 321 therefore detects the stop of the first operation signal and activates control circuit power supply 33 or control circuit 223. This causes cell stack management system 301 to switch to the normal mode.

First communication circuit 321 according to the present embodiment includes second timer 69, and second timer 69 stops outputting the second operation signal when it detects that a preset second time has elapsed. Having detected the stop of the second operation signal, higher-level system 2 activates control circuit power supply 33, control circuit 223, or second communication circuit 22. Stated differently, when second timer 69 detects that a preset second time has elapsed, second timer 69 activates control circuit power supply 33, control circuit 223, or second communication circuit 22, that is, switches to the normal mode.

As described above, in the present embodiment, by forcibly switching to the normal mode on a regular basis, it is possible to detect, without delay, anomalies in the measurement result determination circuit of cell monitoring unit 310, which cannot be detected by intermittent measurement in the low-power mode, as well as failures such as sticking measurement results.

In the configuration example given above, first timer 79 is exemplified as stopping the operation of cell monitoring unit 310, but the configuration of first timer 79 is not limited to this example. For example, first timer 79 may cause signal generation circuit 72 to stop outputting the first operation signal when it detects that the first time has elapsed. First timer 79 may cause signal generation circuit 72 of cell monitoring unit 310 to output a first operation signal indicating an anomaly when it detects that the preset first time has elapsed.

Although second timer 69 is exemplified as stopping the output of the second operation signal in signal generation circuit 67, second timer 69 is not limited to this configuration. For example, second timer 69 may cause signal generation circuit 67 to output a second operation signal indicating an anomaly when it detects that the second time has elapsed.

### (Variations, etc.)

Although the present disclosure has been described based on the above embodiments, the present disclosure is not limited to the above embodiments.

For example, in each of the above embodiments, cell stack 8 is not an element of the cell stack management system, but cell stack 8 may be included in the elements of the cell stack management system.

In each of the above embodiments, the control circuit power supply, the control circuit, and the second communication circuit are deactivated in the low-power mode, but not necessarily all of them need to be deactivated. For example, in the low-power mode, the control circuit and the second communication circuit may be deactivated and the control circuit power supply may be activated. In another example, in the low-power mode, the control circuit power supply and the control circuit may be deactivated and the second communication circuit may be activated. In the low-power mode, at least one of the control circuit power supply, the control circuit, or the second communication circuit may be stopped.

In the above Embodiment 1, battery management unit 20 includes power converter 32, but battery management unit 20 need not necessarily include power converter 32.

In the above Embodiments 2 through 4, battery management units 120, 220, and 320 do not include power converter 32, but may.

The cell monitoring unit may output first operation information indicating not only voltage anomalies but also temperature anomalies, clock anomalies, etc.

The cell stack management system according to each of the above embodiments may be housed in, for example, a single housing, and, alternatively, may be separated into a plurality of housings.

Some or all of the elements included in the cell stack management system according to the above embodiments may be configured in the form of a single system Large Scale Integration (LSI) chip. A system LSI chip is a super multifunctional LSI chip manufactured by integrating a plurality of elements on a single chip. More specifically, a system LSI chip is, for example, a computer system including a microprocessor, ROM, RAM, etc. The RAM stores a computer program. The functions of the system LSI chip are realized by the microprocessor operating according to the computer program.

Some or all of the elements of the cell stack management system according to each of the above embodiments may be configured in the form of a detachable IC card or a stand-alone module. The IC card or module may be a computer system including a microprocessor, ROM, RAM, etc. The IC card or module may include the above-described super multifunctional LSI circuit. The functions of the IC card or module are realized by the microprocessor operating according to a computer program. The IC card and the module may be tamperproof.

The present disclosure may be realized as a computer system including a microprocessor and memory, the memory may store the above-described computer program, and the microprocessor may operate according to the computer program.

Various modifications of the above embodiments that may be conceived by those skilled in the art, as well as embodiments resulting from arbitrary combinations of elements and functions from different embodiments that do not depart from the essence of the present disclosure are included the present disclosure.

For example, the individual communication lines of cell stack management system 1a of Embodiment 1 may be applied to other embodiments of the cell stack management system.

### [Industrial Applicability]

The cell stack management system according to the present disclosure can be used, for example, as a cell stack management system or the like for an in-vehicle cell stack system.

### [Reference Signs List]

1, 1a, 101, 201, 301 cell stack management system
2 higher-level system
8 cell stack
10, 310 cell monitoring unit
11, 311 current measurement unit
20, 120, 220, 320 battery management unit
21, 121, 321 first communication circuit
22 second communication circuit
23, 223 control circuit
31 first power supply
32 power converter
33 control circuit power supply
60, 73 control logic circuit
61, 71 daisy communication unit
62 signal detection unit
63, 74 error detection unit
64 activation unit
66, 76 clock oscillator
67, 72 signal generation circuit
69 second timer
77 ADC
78 multiplexer
79 first timer
80 power supply control circuit
81 power storage cell
82 resistor element
L10, L11 individual communication line
NW1 first communication network
NW2 second communication network
NW3 third communication network

## Claims

1. A cell stack management system that manages a cell stack including a plurality of power storage cells connected in series or parallel, the cell stack management system comprising:
a cell monitoring unit that is connected to the plurality of power storage cells and measures an output voltage of at least one of the plurality of power storage cells;
a battery management unit that manages the cell stack; and
a first communication network that connects the cell monitoring unit and the battery management unit, wherein
the battery management unit includes:
a first communication circuit connected to the first communication network;
a second communication circuit connected to a second communication network for connecting to a higher-level system of the cell stack management system;
a control circuit that controls the battery management unit; and
a control circuit power supply that supplies power to the control circuit,
the cell stack management system includes, as modes of operation, a normal mode and a low-power mode that consumes less power than the normal mode,
in the low-power mode, at least one of the control circuit power supply, the control circuit, or the second communication circuit is deactivated, and
during transition from the low-power mode to the normal mode, the first communication circuit activates at least one of the control circuit power supply, the control circuit, or the second communication circuit.

2. The cell stack management system according to claim 1, wherein
the cell monitoring unit outputs a first operation signal indicating a state of the plurality of power storage cells to the first communication circuit,
when at least one of the control circuit power supply, the control circuit, or the second communication circuit is deactivated and the cell monitoring unit detects an anomaly, the cell monitoring unit outputs the first operation signal indicating an anomaly, and
when the first communication circuit receives the first operation signal indicating an anomaly, the first communication circuit activates the control circuit power supply, the control circuit, and the second communication circuit.

3. The cell stack management system according to claim 1, wherein
the control circuit power supply is activated by the first communication circuit or the higher-level system.

4. The cell stack management system according to claim 3, wherein
the second communication circuit is deactivated in the low-power mode,
when activated by the first communication circuit, the second communication circuit notifies the higher-level system via the second communication network of the activation by the first communication circuit, and
the higher-level system activates at least one of the control circuit power supply or the control circuit via the second communication network.

5. The cell stack management system according to claim 2, wherein
when the control circuit or the second communication circuit is deactivated, the first operation signal transmitted by the cell monitoring unit is a repeating pulse signal.

6. The cell stack management system according to claim 2 or 5, wherein
the battery management unit includes a first power supply and a power converter which supply power to the first communication circuit,
the battery management unit includes a function for deactivating the first power supply in the low-power mode, and
when the first power supply is deactivated, the power converter converts a signal transmitted in the first communication network to direct-current power, and supplies the direct-current power to the first communication circuit.

7. The cell stack management system according to claim 6, wherein
when the first power supply is deactivated and the cell monitoring unit detects an anomaly, the cell monitoring unit outputs the first operation signal indicating an anomaly, and
when the first communication circuit receives the first operation signal indicating an anomaly via the first communication network, the first communication circuit activates the first power supply and stops output of the direct-current power by the power converter.

8. A cell stack management system that manages a cell stack including a plurality of power storage cells connected in series or parallel, the cell stack management system comprising:
a cell monitoring unit that is connected to the plurality of power storage cells and measures an output voltage of at least one of the plurality of power storage cells;
a battery management unit that manages the cell stack; and
a first communication network that connects the cell monitoring unit and the battery management unit, wherein
the battery management unit includes:
a first communication circuit connected to the first communication network;
a second communication circuit connected to a second communication network for connecting to a higher-level system of the cell stack management system; and
a control circuit that controls the battery management unit, and
the first communication circuit is connected to a third communication network for connecting to the higher-level system.

9. The cell stack management system according to claim 8, wherein
when at least one of the control circuit or the second communication circuit cannot communicate, the first communication circuit communicates with the higher-level system via the third communication network.

10. The cell stack management system according to claim 8 or 9, wherein
when at least one of the control circuit or the second communication circuit is deactivated:
the cell monitoring unit transmits a first operation signal to the first communication circuit; and
the first communication circuit transmits, via the third communication network, a second operation signal indicating that the cell monitoring unit and the first communication circuit are in operation.

11. The cell stack management system according to claim 10, wherein
the first operation signal and the second operation signal that are transmitted when at least one of the control circuit or the second communication circuit is deactivated are repeating pulse signals.

12. The cell stack management system according to claim 10 or 11, wherein
when the control circuit or the second communication circuit is deactivated and the cell monitoring unit detects an anomaly, the cell monitoring unit outputs the first operation signal indicating an anomaly, and
when the first communication circuit receives the first operation signal indicating an anomaly via the first communication network, the first communication circuit outputs the second operation signal indicating an anomaly.

13. The cell stack management system according to any one of claims 10 to 12, wherein
when the first communication circuit outputs the second operation signal indicating an anomaly, the higher-level system activates the control circuit or the second communication circuit.

14. The cell stack management system according to any one of claims 1 to 13, wherein
before deactivating, the control circuit diagnoses a state of the first communication circuit.

15. The cell stack management system according to any one of claims 10 to 13, wherein
before the control circuit deactivates, the first communication circuit outputs the second operation signal to at least one of the control circuit or the higher-level system, and
the at least one of the control circuit or the higher-level system diagnoses a state of the first communication circuit based on the second operation signal.

16. The cell stack management system according to any one of claims 10 to 13 and 15, wherein
before the control circuit deactivates, the first communication circuit outputs, to the control circuit, a control activation signal for activating the control circuit, and
the control circuit diagnoses a state of the first communication circuit based on the control activation signal.

17. The cell stack management system according to any one of claims 10 to 13, 15, and 16, wherein
the cell monitoring unit includes a first timer, and
when the first timer detects that a preset first time has elapsed, the first timer causes the cell monitoring unit to output the first operation signal indicating an anomaly.

18. The cell stack management system according to claim 17, wherein
when the first timer detects that the preset first time has elapsed, the first timer stops operation of the cell monitoring unit.

19. The cell stack management system according to any one of claims 10 to 13 and 15 to 18, wherein
when at least one of the control circuit or the second communication circuit is deactivated and the first operation signal is stopped, and when at least one of the control circuit or the second communication circuit is deactivated and there is an anomaly in the first communication circuit, the first communication circuit stops transmitting the second operation signal.

20. The cell stack management system according to claims 10 to 13 and 15 to 19, further comprising:
a control circuit power supply that supplies power to the control circuit, wherein
when the first operation signal is stopped, the first communication circuit activates at least one of the control circuit power supply, the control circuit, or the second communication circuit.

21. The cell stack management system according to any one of claims 10 to 13 and 15 to 20, wherein
the first communication circuit includes a second timer, and
when the second timer detects that a preset second time has elapsed, the second timer stops the second operation signal.

22. The cell stack management system according to any one of claims 10 to 13 and 15 to 19, further comprising:
a control circuit power supply that supplies power to the control circuit, wherein
the first communication circuit includes a second timer, and
when the second timer detects that a preset second time has elapsed, the second timer activates at least one of the control circuit power supply, the control circuit, or the second communication circuit.
